# EUROPEAN PATENT APPLICATION

(11) **EP 4 199 251 A1**
(43) Date of publication of application: **21.06.2023**
(21) Application number: 21857639.5
(22) Date of filing: 16.08.2021
(51) Int. Cl.: H01Q 1/24

(54) **CONFIGURABLE TUNING CIRCUIT, MATCHING NETWORK, ANTENNA SYSTEM, AND TERMINAL DEVICE**

(30) Priority: 18.08.2020 CN 202021727256 U
(71) Applicant: Huawei Technologies Co., Ltd., Shenzhen, Guangdong 518129 (CN)
(72) Inventor: XIONG, Enliang, Shenzhen, Guangdong 518129 (CN); ZHANG, Xiaowei, Shenzhen, Guangdong 518129 (CN); SUN, Qiao, Shenzhen, Guangdong 518129 (CN); CHEN, Dan, Shenzhen, Guangdong 518129 (CN)
(74) Representative: Gill Jennings & Every LLP
(86) International application number: PCT/CN2021/112866
(87) International publication number: WO 2022/037545

(57) **Abstract**

This application provides a configurable tuned circuit. The configurable tuned circuit includes a plurality of terminals, a first reactance element, and a plurality of switching elements. The plurality of terminals include a first terminal, a second terminal, a third terminal, a fourth terminal, and a fifth terminal. The first reactance element is coupled between the first terminal and the second terminal. The plurality of switching elements include a first switching element and a second switching element. The first switching element is coupled between the third terminal and the fourth terminal, and the first switching element selectively conducts the third terminal and the fourth terminal. The second switching element is coupled between the second terminal and the fifth terminal, and the second switching element selectively conducts the second terminal and the fifth terminal. The configurable tuned circuit may have characteristics of a high topological degree of freedom and strong universality on the premise that there are few reactance elements. This application further provides a matching network, an antenna apparatus, and a terminal device that include the configurable tuned circuit, to help reduce a requirement of an antenna on clear space.

## Description

This application claims priority to Chinese Patent Application No. 202021727256.X, filed with the China National Intellectual Property Administration on August 18, 2020, and entitled "CONFIGURABLE TUNED CIRCUIT, MATCHING NETWORK, ANTENNA SYSTEM, AND TERMINAL DEVICE", which is incorporated herein by reference in its entirety.

### TECHNICAL FIELD

This application relates to the field of electronic devices, and more specifically, to a configurable tuned circuit, a matching network, an antenna system, and a terminal device.

### BACKGROUND

In recent years, due to a market requirement, development trends of electronic devices such as a mobile phone mainly include a large screen-to-body ratio, a plurality of cameras, an ultra-thin thickness, and the like. Therefore, space in which components can be disposed in an electronic device becomes smaller. However, with development of communication technologies, an antenna of a mobile phone needs to cover a plurality of frequency bands, but it is difficult for a single antenna to simultaneously cover a plurality of frequency bands. Therefore, more antennas need to be disposed, and more radio frequency front-end components need to be disposed. How to dispose more antennas and radio frequency front-end components in limited space to improve performance of the antennas becomes a major problem in terminal antenna design and radio frequency front-end design.

### SUMMARY

This application provides a configurable tuned circuit, a matching network, an antenna system, and a terminal device, to implement more flexible tuning by using a smaller device area, to reduce a requirement of an antenna on clear space.

According to a first aspect, a configurable tuned circuit is provided. The configurable tuned circuit includes a plurality of terminals, a first reactance element, and a plurality of switching elements. The plurality of terminals include a first terminal, a second terminal, a third terminal, a fourth terminal, and a fifth terminal. The first reactance element is coupled between the first terminal and the second terminal. The plurality of switching elements include a first switching element and a second switching element. The first switching element is coupled between the third terminal and the fourth terminal, and the first switching element selectively conducts the third terminal and the fourth terminal. The second switching element is coupled between the second terminal and the fifth terminal, and the second switching element selectively conducts the second terminal and the fifth terminal.

In the configurable tuned circuit, the first switching element is a separate branch, and two ends of the first switching element each may be connected by using a terminal, thereby increasing a degree of freedom of application of the configurable tuned circuit. The first reactance element and the second switching element each are coupled to the second terminal, to effectively reduce the terminals of the configurable tuned circuit. Therefore, the configurable tuned circuit may have characteristics of a high topological degree of freedom and strong universality on the premise that there are few reactance elements.

With reference to the first aspect, in some implementations of the first aspect, the first reactance element is a variable capacitor, which helps perform tuning and reduce an area of the configurable tuned circuit.

According to the configurable tuned circuit in this embodiment of this application, a range of a capacitance value of the variable capacitor is 0.7 picofarad to 2.7 picofarads. This can implement tuning of a plurality of common frequency bands.

With reference to the first aspect, in some implementations of the first aspect, the variable capacitor is configured to switch at least eight different capacitance values. When the variable capacitor has eight different capacitance values, a size of a tuning component is not excessively large, and there are many tunable circuit states.

With reference to the first aspect, in some implementations of the first aspect, the first reactance element is a variable inductor, and the variable inductor is combined with a switching assembly to implement more circuit states, thereby implementing different tuning states, and simplifying the tuned circuit.

With reference to the first aspect, in some implementations of the first aspect, the plurality of terminals further include a sixth terminal, and the plurality of switching elements further include a third switching element. The third switching element is coupled between the second terminal and the sixth terminal. The second switching element selectively conducts the second terminal and the sixth terminal. This helps implement more tuning states without occupying excessive areas.

With reference to the first aspect, in some implementations of the first aspect, the configurable tuned circuit further includes at least one ground terminal, and the ground terminal is coupled to the first terminal. This helps implement grounding of the capacitor.

With reference to the first aspect, in some implementations of the first aspect, the configurable tuned circuit includes a first ground terminal and a second ground terminal. Some terminals are connected to the first ground terminal, and some other terminals are connected to the second ground terminal. Therefore, two small ground terminals may be disposed, and no excessive ground area is occupied. In this way, a matching network formed by the configurable tuned circuit may be coupled between an antenna radiator and a ground point (used for grounding of the antenna radiator). This helps reduce a requirement of the antenna for clear space.

With reference to the first aspect, in some implementations of the first aspect, a size of the ground terminal is the same as those of some or all of the plurality of terminals. This helps implement array arrangement of the terminals, and implement miniaturization of a component.

With reference to the first aspect, in some implementations of the first aspect, the configurable tuned circuit further includes a signal controller. The signal controller is separately coupled to the first switching element, the second switching element, and the first reactance element, to conveniently configure the first switching element, the second switching element, and the first reactance element, thereby implementing a plurality of tuning states.

With reference to the first aspect, in some implementations of the first aspect, the plurality of terminals further include a user identification terminal, a ground terminal, a serial data terminal, a voltage input/output terminal, and a serial clock terminal. The user identification terminal, the ground terminal, the serial data terminal, the voltage input/output terminal, and the serial clock terminal are separately coupled to the signal controller, to facilitate a communication connection between the signal controller and a processor, so that the processor can transmit control information to the signal controller, to help configure the first switching element, the second switching element, and the first reactance element.

According to a second aspect, an embodiment of this application provides a matching network. The matching network includes the configurable tuned circuit in the first aspect and at least one external component. The external component is coupled to one or more of a plurality of switching elements by using a terminal. The matching network formed through cooperation of the external component and the configurable tuned circuit may help tune an antenna.

With reference to the second aspect, in some implementations of the first aspect, the matching network includes a plurality of external components. Each external component is coupled to one switching element, to implement more convenient tuning.

With reference to the second aspect, in some implementations of the first aspect, the external component is a capacitor or an inductor, for example, an adjustable capacitor or an adjustable inductor, and cooperates with the switching elements in the configurable tuned circuit, to implement a plurality of tuning states.

According to a third aspect, an embodiment of this application provides an antenna system. The antenna system includes a first antenna radiator, a feed point, a ground point, and the matching network in the second aspect. The matching network is coupled between the first antenna radiator and the feed point, to perform impedance tuning. Alternatively, the matching network is coupled between the first antenna radiator and the ground point, to perform aperture tuning.

With reference to the third aspect, in some implementations of the first aspect, the antenna system further includes a second antenna radiator. Two switching elements are respectively connected in series with two external components, to form a first branch and a second branch. The first branch is coupled between the first antenna radiator and the feed point. The second branch is coupled between the second antenna radiator and the feed point. A first reactance element is coupled between the feed point and the ground. The configurable tuned circuit may be configured to switch and select the antenna radiators.

According to a fourth aspect, a terminal device is provided. The terminal device includes the antenna system in any one of the third aspect and possible implementations of the third aspect and a processor. For a beneficial effect that can be achieved by the terminal device, refer to the beneficial effect in the corresponding configurable tuned circuit provided above. Details are not described herein again.

### BRIEF DESCRIPTION OF DRAWINGS

FIG. 1 is a schematic diagram of a wireless communication system according to an embodiment of this application;
FIG. 2 is a schematic diagram of a configurable tuned circuit according to an embodiment of this application;
FIG. 3 is a schematic diagram of a package structure of a configurable tuned circuit according to an embodiment of this application;
FIG. 4a to FIG. 4f are schematic diagrams of a matching network according to an embodiment of this application;
FIG. 5a to FIG. 5i are schematic diagrams of an antenna system according to an embodiment of this application; and
FIG. 6a to FIG. 6c are schematic diagrams of an antenna system according to an embodiment of this application.

### DESCRIPTION OF EMBODIMENTS

The following describes technical solutions of this application with reference to the accompanying drawings.

Terms used in the following embodiments are merely intended to describe particular embodiments, but are not intended to limit this application. The terms "one", "a" and "this" of singular forms used in this specification and the appended claims of this application are also intended to include expressions such as "one or more", unless otherwise specified in the context clearly. It should be further understood that, in the embodiments of this application, "one or more" refers to one, two, or more; "and/or" describes an association relationship between associated objects, and represents that three relationships may exist. For example, A and/or B may represent the following three cases: Only A exists, both A and B exist, and only B exists, where A and B may be singular or plural. The character "/" usually indicates an "or" relationship between associated objects.

Reference to "one embodiment", "some embodiments", or the like described in this specification means that a specific characteristic, structure, or feature described with reference to one or more embodiments is included in the one or more embodiments of this application. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

With development of communication technologies, an emerging wireless communication technology (also referred to as a 5^{th} generation mobile communication technology, English: 5^{th} generation mobile networks or 5^{th} generation wireless systems, 5^{th}-Generation, or 5^{th}-Generation New Radio, 5G, a 5G technology, or 5G NR for short) is widely considered as a next-generation wireless communication standard that goes beyond the current 3^{rd}-generation (3G) communication standards (for example, wideband code division multiple access, wideband code division multiple access, WCDMA for short) and the 4^{th}-generation (4G) communication standards (for example, long term evolution LTE). Compared with wireless communication systems based on the 3G communication standards and the 4G communication standards, a 5G wireless communication system provides a higher data rate and a lower latency. In addition, a radio frequency signal of the 5G communication system covers a wider frequency band, including a 5G low frequency band (less than 1 GHz), a 5G intermediate frequency band (1 GHz to 6 GHz), and a 5G high frequency band (more than 24 GHz). An increase of new frequency bands results in an increase of antennas. In addition, the 5G technology supports channel transmitting, and each transmit link needs an independent antenna. Therefore, compared with a 4G wireless communication system, there is a large increase in a quantity of antennas in the 5G wireless communication system, and more matching networks need to be disposed for impedance matching. However, space in a housing of an electronic device is limited, and components such as a battery and a camera occupy a large amount of space, leaving small space for a radio frequency communication system. As the radio frequency communication system includes more electronic components, it is difficult to accommodate more electronic components in the housing.

For example, technical solutions in the embodiments of this application may be applied to various electronic devices with a wireless communication system, and may be applied to electronic devices such as a mobile phone, a tablet computer, a personal computer (personal computer, PC), a personal digital assistant (personal digital assistant, PDA), a smart watch, a netbook, a wearable electronic device, an augmented reality (augmented reality, AR) device, a virtual reality (virtual reality, VR) device, a vehicle-mounted device, a smart car, a smart sound, a robot, smart glasses, a base station, or a mobile station. This is not limited in the embodiments of this application. The electronic device may include a housing, a display screen configured to display, a wireless communication system configured to perform wireless charging, and the like.

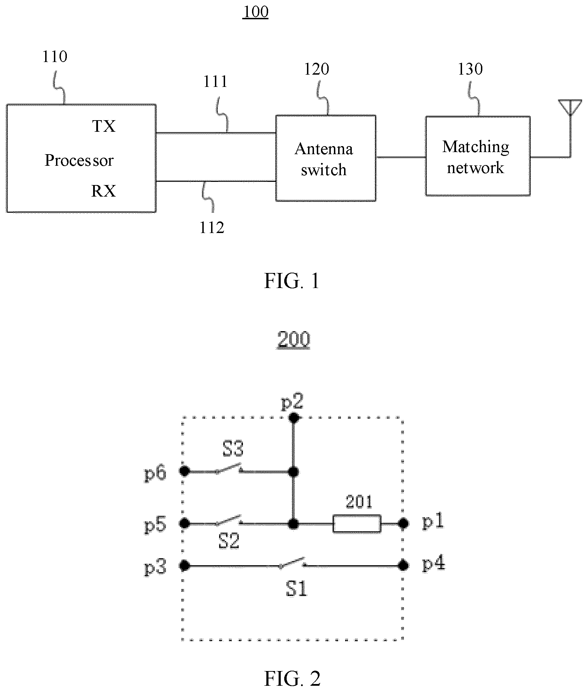

FIG. 1 shows a schematic diagram of a wireless communication system 100 in an electronic device according to an embodiment of this application. The wireless communication system 100 is located in a housing of the electronic device. The wireless communication system 100 includes a processor 110, an antenna switch 120, a matching network 130, and an antenna 140.

The processor 110 may include one or more processing units. For example, the processor 110 may include an application processor (application processor, AP), a modem processor, a graphics processing unit (graphics processing unit, GPU), an image signal processor (image signal processor, ISP), a neural-network processing unit (neural-network processing unit, NPU), a controller, a video codec, a digital signal processor (digital signal processor, DSP), a baseband, and/or a radio frequency integrated circuit (RFIC). The controller may generate an operation control signal based on an instruction operation code and a time sequence signal, to complete control of instruction fetching and instruction execution. In some embodiments, the baseband and the radio frequency integrated circuit may be integrated into an integrated circuit. In some embodiments, the baseband and the radio frequency circuit each may be an independent component.

A memory may be further disposed in the processor 110, and is configured to store instructions and data. In some embodiments, the memory in the processor 110 is a cache. The memory may store instructions or data that has been used or is cyclically used by the processor 110. If the processor 110 needs to use the instructions or the data again, the processor may directly invoke the instructions or the data from the memory. This avoids repeated access, reduces waiting time of the processor 110, and improves system efficiency.

The baseband is configured to synthesize a to-be-transmitted baseband signal, or/and configured to decode a received baseband signal. Specifically, during transmitting, the baseband encodes a voice or another data signal into a baseband signal (a baseband code) used for transmitting. During receiving, the baseband decodes a received baseband signal (a baseband code) into a voice or another data signal. The baseband may include components such as an encoder, a decoder, and a baseband processor. The encoder is configured to synthesize a to-be-transmitted baseband signal, and the decoder is configured to decode a received baseband signal. The baseband processor may be a microprocessor (MCU), and the baseband processor may be configured to control the encoder and the decoder. For example, the baseband processor may be configured to complete scheduling of coding and decoding, and communication between the encoder and the decoder, and may be used for driving a peripheral device (the baseband processor may transmit an enable signal to a component outside the baseband to enable the component outside the baseband). The baseband may perform frequency modulation on a signal according to a wireless communication technology. The wireless communication technology may include a global system for mobile communications (global system for mobile communications, GSM), a general packet radio service (general packet radio service, GPRS), code division multiple access (code division multiple access, CDMA), wideband code division multiple access (wideband code division multiple access, WCDMA), time-division code division multiple access (time-division code division multiple access, TD-SCDMA), long term evolution (long term evolution, LTE), a 5G technology, a wireless local area network (wireless local area networks, WLAN) (for example, a wireless fidelity (wireless fidelity, Wi-Fi) network), a Bluetooth (Bluetooth, BT), a global navigation satellite system (global navigation satellite system, GNSS), frequency modulation (frequency modulation, FM), a near field communication (near field communication, NFC) technology, an infrared (infrared, IR) technology, and the like.

The radio frequency integrated circuit is configured to process the baseband signal to form a transmit (Transmit, TX) signal, and transmit the transmit signal to the antenna 140 through a transmit link 111; and/or, the radio frequency integrated circuit is configured to process a receive (Receive, RX) signal to form a baseband signal, and transmit the formed baseband signal to the baseband for decoding.

The antenna 140 is configured to transmit and receive an electromagnetic wave signal (a radio frequency signal). The antenna 140 may include a plurality of antennas or a plurality of groups of antennas (the plurality of groups of antennas include more than two antennas), and each antenna or the plurality of groups of antennas may be configured to cover a single or a plurality of communication bands. The plurality of antennas may be one or more of a multi-frequency antenna, an array antenna, or an on-chip (on-chip) antenna.

The processor 110 is coupled to the antenna 140 to implement various functions associated with transmitting and receiving radio frequency signals. For example, when the electronic device transmits a signal, the baseband synthesizes to-be-transmitted data (a digital signal) into a to-be-transmitted baseband signal, and the baseband signal is converted into a transmit signal TX (a radio frequency signal) by the radio frequency integrated circuit, and the transmit signal TX is transmitted to the antenna switch 120 through the transmit link 111. In some embodiments, the transmit link 111 may include a power amplifier and a harmonic filter. After being amplified by the power amplifier, the transmit signal TX output by the radio frequency integrated circuit is sent to the harmonic filter, and the harmonic filter filters a transmit frequency of the amplified transmit signal TX. The antenna switch 120 may be configured to selectively electrically connect the transmit link 111 or a receive link 112 to the matching network 130. The matching network 130 is configured to match impedance of the antenna, and the matching network 130 is coupled to the antenna 140. The antenna 140 transmits the transmit signal TX.

When the electronic device needs to receive a signal, the antenna 140 transmits a received signal RX (a radio frequency signal) to the antenna switch 120 over the matching network 130. The antenna switch 120 transmits the radio frequency signal RX to the radio frequency integrated circuit. The radio frequency integrated circuit processes the radio frequency signal RX into a baseband signal. The radio frequency integrated circuit converts the processed baseband signal into data, and then transmits the data to a corresponding application processor. A path through which a radio frequency integrated signal is transmitted by the antenna switch 120 to the processor 110 is the receive link 112.

In actual application, impedance of the antenna 140 in the electronic device is easily affected by an external environment, for example, common actions of a user such as holding the electronic device, placing the electronic device near a head, or placing the electronic device into a pocket may cause a significant change in the impedance of the antenna 140. For the wireless communication system, communication performance is deteriorated when an impedance mismatch occurs in the antenna 140. For example, efficiency of the power amplifier is reduced, and this results in reduction of transmit power, increasing of overall power consumption, and deterioration of a noise factor of a receiver. As a result, sensitivity is reduced. The matching network 130 may flexibly tune the impedance of the antenna 140, to reduce impact of a change in the impedance of the antenna 140 on performance of the wireless communication system, thereby improving airtime of a mobile phone, and improving communication quality. In another aspect, for a broadband antenna, the matching network 130 may further tune the impedance of the antenna 140, thereby improving efficiency of the antenna 140 within an operating frequency band, and improving communication quality.

The matching network 130 includes a configurable tuned circuit and an external component, and the configurable tuned circuit cooperates with the external component to tune the impedance of the antenna 140. FIG. 2 is a schematic diagram of a configurable tuned circuit 200 according to an embodiment of this application. As shown in FIG. 2, the configurable tuned circuit 200 includes at least one first reactance element 201, a plurality of terminals, and a plurality of switching elements. The plurality of terminals all may be external components, for example tuning components such as inductors or capacitors, and a debugging state is added. In a specific embodiment, the terminals of the configurable tuned circuit 200 include a first terminal p1, a second terminal p2, a third terminal p3, a fourth terminal p4, and a fifth terminal p5. The switching elements include a first switching element S1 and a second switching element S2. Two ends of the first reactance element 201 are respectively coupled to the first terminal p1 and the second terminal p2. Two ends of the first switching element S1 are respectively coupled to the third terminal p3 and the fourth terminal p4, and the first switching element S1 selectively conducts the third terminal p3 and the fourth terminal p4. Two ends of the second switching element S2 are respectively coupled to the fifth terminal p5 and the second terminal p2, and the second switching element S2 selectively conducts the fifth terminal p5 and the second terminal p2. In some embodiments, the first reactance element 201 may further be grounded. For example, the end, coupled to the first terminal p1, of the first reactance element 201 is grounded. In some embodiments, the first reactance element 201 may further be grounded. For example, the end, coupled to the first terminal p1, of the first reactance element 201 is grounded.

In the configurable tuned circuit 200, the first switching element S 1 is a separate branch, and two ends of the first switching element S1 each may be connected to a terminal, thereby increasing a degree of freedom of application of the configurable tuned circuit 200. The first reactance element 201 and the second switching element S2 have a connection node (that is, both are coupled to the second terminal p2), to effectively reduce the terminals of the configurable tuned circuit 200. The configurable tuned circuit 200 may have characteristics of a high topological degree of freedom and strong universality on the premise that there are few reactance elements.

In some embodiments, the configurable tuned circuit 200 may further include a signal controller (not shown in the figure). The signal controller may generate an operation control signal based on an instruction operation code and a time sequence signal, and complete control of fetching instructions and executing the instructions, to control an on/off state of each switching element. After generating the control signal, the signal controller transmits the control signal to each switching element. In addition, the configurable tuned circuit 200 further includes at least one of a user identification (user, identification, USID) terminal, a ground (ground, GND) terminal, a serial data (serial data, SDATA) terminal, a voltage input/output (voltage input/output, VIO) terminal, or a serial clock (serial clock, SCLK) terminal. The USID terminal is configured to identify an identification code of a component controlled by a mobile industry processor interface (mobile industry processor interface, MIPI), which is equivalent to numbering each component, and the control signal is sent to a corresponding component based on a corresponding number. The GND terminal is used for grounding of the configurable tuned circuit 200. The SDATA terminal is a data interface of a component, and is configured to input control data. The VIO terminal is connected to a power supply of the component, and is configured to input a power supply signal. The SCLK terminal is configured to input a clock control signal. In addition, the configurable tuned circuit 200 may further include a substrate configured to carry elements in the configurable tuned circuit 200.

The first reactance element 201 may play a tuning role in the configurable tuned circuit 200. In some embodiments, the reactance element is a capacitor and/or an inductor. For example, the capacitor may adjust an impedance position of an antenna radiator on a Smith chart from a first quadrant or a second quadrant to a third quadrant or a fourth quadrant, and the inductor may adjust the impedance position of the antenna radiator on the Smith chart from the third quadrant or the fourth quadrant to the first quadrant or the second quadrant. In addition, through combination and connection of a plurality of capacitors and/or a plurality of inductors, the impedance position on the Smith chart can be adjusted within a wider frequency band.

In some specific embodiments, the reactance element is a variable capacitor. In other words, the reactance element is a capacitor element that can be adjusted to a plurality of capacitance values. That is, the variable capacitor can implement different circuit states and implement different tuning states. For example, the first reactance element 201 may be adjusted to two different capacitance values: a capacitance value 1 and a capacitance value 2. In this case, the capacitance value 1 and the capacitance value 2 may respectively correspond to different tuning degrees, and therefore may correspond to different frequency band ranges. Different capacitance values of the reactance element may be switched by the signal controller. The more adjustable capacitance values of the variable capacitor, the more flexible the tuning degrees that may be implemented are. The variable capacitor may be an SSC capacitor (a switch array capacitor), and different capacitance values may be configured through switching of an array switch. The configurable tuned circuit 200 may be implemented in a smaller component package. The switch array capacitor and the switching element may be integrated in an integrated circuit, to effectively reduce an area of the configurable tuned circuit, thereby saving resources of a circuit board.

In some embodiments, a range of capacitance values of the variable capacitor is 0.7 picofarad to 2.7 picofarads, can cover wide frequency band tuning, and can implement frequency band tuning, for example, from 700 MHz to 6 GHz. For example, eight different capacitance values of the variable capacitor respectively are 0.7, 1, 1.3, 1.65, 1.9, 2.2, 2.4, and 2.7. In other words, the eight different capacitance values are evenly distributed within a range of 0.7 picofarad to 2.7 picofarads, thereby facilitating implementation of even tuning in a large frequency band range.

The variable capacitance may be combined with the switching element, to implement more circuit states. For example, the variable capacitor may be switched to eight different capacitance values, and the switching element may implement four different circuit connection states. In this case, the configurable tuned circuit 200 may implement 8×4 circuit states, thereby implementing flexible tuning configuration.

In some embodiments, the configurable tuned circuit 200 may further include a third switching element S3 and a sixth terminal p6. Two ends of the third switching element S3 are respectively coupled to the sixth terminal p6 and the second terminal p2, and the third switching element S3 selectively conducts the sixth terminal p6 and the second terminal p2. The first reactance element 201, the second switching element S2, and the third switching element S3 each are coupled to the second terminal p2, to more effectively reduce the terminals of the configurable tuned circuit 200, so that the configurable tuned circuit 200 may have a higher topological degree of freedom, and a packaging area of the configurable tuned circuit 200 is not increased. The third switching element S3 may implement two different circuit connection states. The configurable tuned circuit 200 may implement 8×(4+2) circuit states on the premise that the variable capacitor can be switched to at least eight different capacitance values. In another embodiment, the configurable tuned circuit 200 may further include more switching elements, or reactance elements, to implement more flexible tuning.

In some embodiments, the reactance element is a variable inductor, that is, the reactance element may be an inductance element that can be adjusted to a plurality of inductance values. For example, the reactance element may be adjusted to two different inductance values: an inductance value 1 and an inductance value 2. In this case, the inductance value 1 and the inductance value 2 may respectively correspond to different tuning degrees, and therefore may correspond to different frequency band ranges. Specifically, the signal controller is further configured to switch different inductance values of the reactance element.

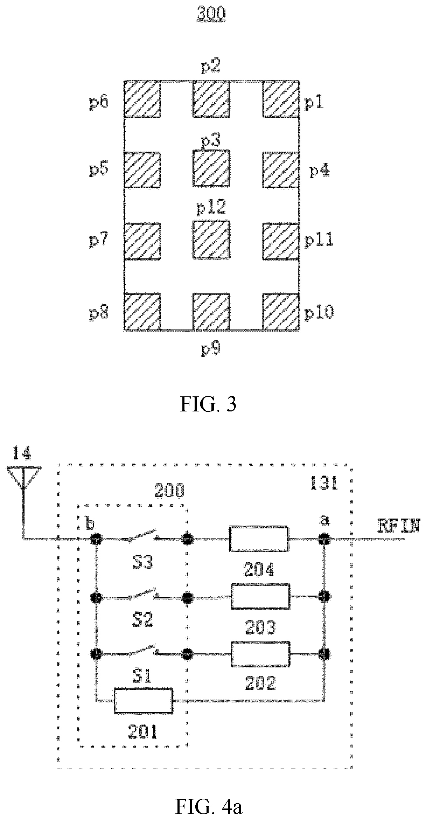

FIG. 3 is a schematic diagram of packaging of a configurable tuned circuit according to an embodiment of this application. As shown in FIG. 3, a package structure 300 of a configurable tuned circuit 200 includes 12 terminals, where a seventh terminal p7, an eighth terminal p8, a ninth terminal p9, a tenth terminal p10, an eleventh terminal p11, and a twelfth terminal p12 each are respectively a ground end, an SDATAend, a VIO end, an SCLK end, a USID end, and a ground end. The package structure 300 has the two ground ends, so that a degree of isolation between a radio frequency signal and a digital control signal (MIPI) can be well improved. In addition, because there are the two ground ends, an area of the ground ends is small, and an effect on an antenna is small, so that the configurable tuned circuit can be coupled to a ground feed of the antenna. In addition, a volume of the package structure 300 is small, so that less area of a circuit board may be occupied.

The configurable tuned circuit 200 may be used in a matching network to tune the antenna.

Coupled states of the terminals of the configurable tuned circuit 200 may be configured, to implement matching networks of different topology structures. FIG. 4a to FIG. 4f are schematic diagrams of equivalent circuits of the matching network according to this embodiment of this application. The configurable tuned circuit 200 may cooperate with the coupled states of the terminals to implement more topology structures.

When the first terminal p1 is coupled to a first node a, the second terminal p2 is coupled to a second node b, the third terminal p3 is coupled to a first end of a second reactance element 202, the fourth terminal p4 is coupled to the second node b, the fifth terminal p5 is coupled to a first end of a third reactance element 203, and the sixth terminal p6 is coupled to a first end of a fourth reactance element 204, a full series-type matching network 131 shown in FIG. 4a is formed. The first node a and the second node b may be used as access nodes to access a position, for example, a main channel. For example, in some embodiments, the first node a may be coupled to an antenna switch to receive a radio frequency input signal RFIN (namely, a transmit signal RX), and the second node b may be coupled to an antenna 14, so that a channel through which the radio frequency input signal RFIN is sent to the antenna 14 is a main channel. When impedance of the antenna 14 changes, the configurable tuned circuit 200 may configure conductive states of the first switching element S1, the second switching element S2, and the third switching element S3, and a capacitance value of an adjustable capacitor, to tune the impedance of the antenna 14. One or more of the second reactance element 202, the third reactance element 203, and the fourth reactance element 204 may be capacitors or inductors, or some of the second reactance element 202, the third reactance element 203, and the fourth reactance element 204 are capacitors, and the remaining is an inductor. In some other embodiments, the second node b may be coupled to the antenna switch, to receive the radio frequency input signal RFIN (namely, the transmit signal RX), and the first node a may be coupled to the antenna 14. In this case, a channel through which the radio frequency input signal RFIN is sent to the antenna 14 is also a main channel.

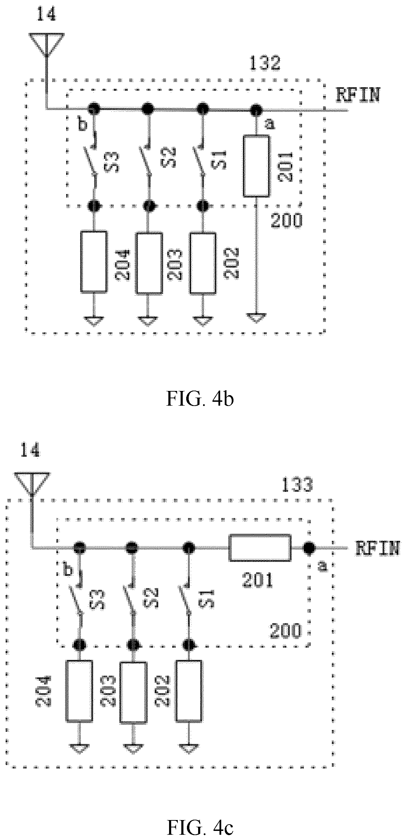

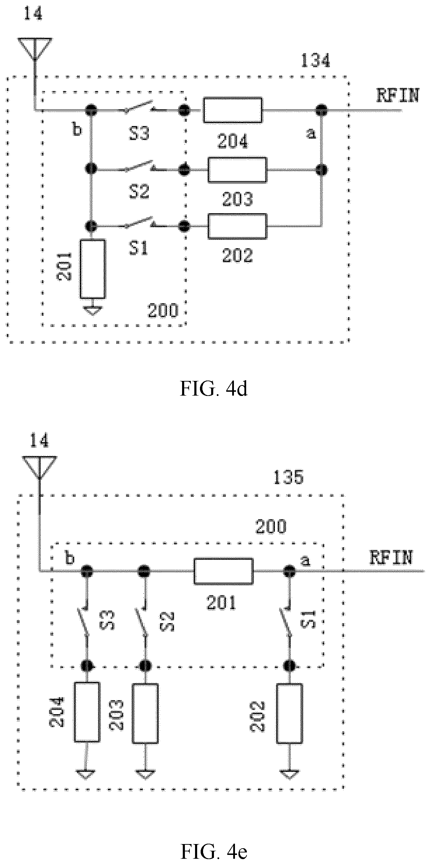

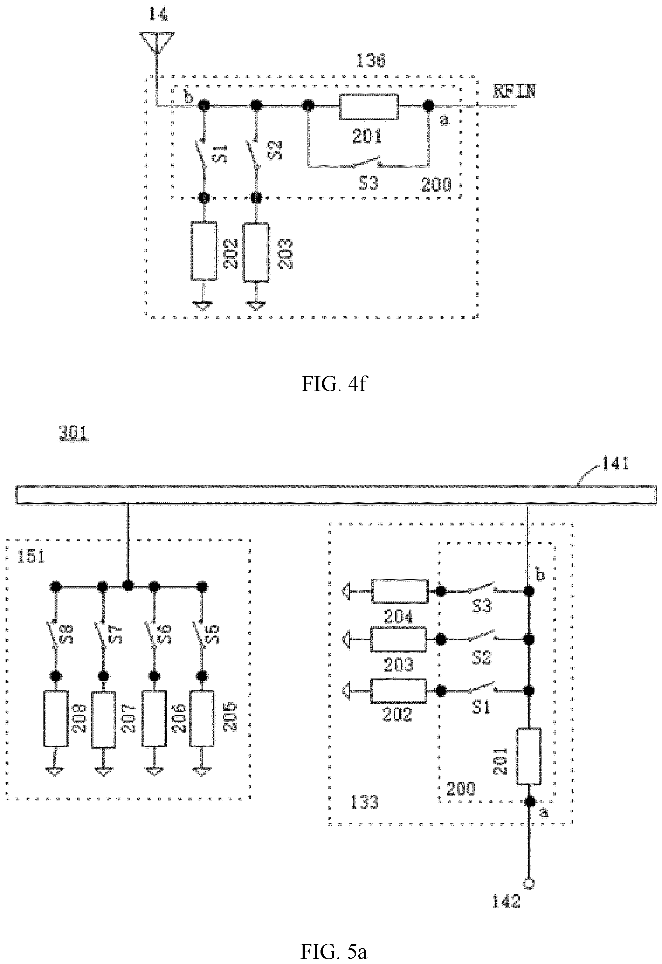

In addition, the configurable tuned circuit 200 may further form a full series-type matching network 132 shown in FIG. 4b, an L-type matching network 133 shown in FIG. 4c, an L-type matching network 134 shown in FIG. 4d, a full series-type matching network 135 shown in FIG. 4e, and an L-type matching network 136 shown in FIG. 4f. The matching network 132, the matching network 133, the matching network 134, the matching network 135, and the matching network 136 are not described herein again. When the impedance of the antenna 14 changes, the configurable tuned circuit 200 may configure the conductive states of the first switching element S1, the second switching element S2, and the third switching element S3, and the capacitance value of the adjustable capacitor, to tune the impedance of the antenna 14. One or more of the external components (the second reactance element 202, the third reactance element 203, or the fourth reactance element 204) may be capacitors or inductors, or some of the second reactance element 202, the third reactance element 203, and the fourth reactance element 204 are capacitors, and the remaining is an inductor.

In a specific application scenario, the matching networks formed by the configurable tuned circuit 200 may be used in various application scenarios of antenna tuning and switching, such as impedance tuning, aperture tuning, and antenna switching. In addition, the configurable tuned circuit 200 may be used in different antenna forms such as an IFA antenna (an inverted F antenna), and a PIFA antenna (a linear inverted F antenna). Specifically, a different topology form may be used according to a requirement of an antenna. The matching networks are connected in series or in parallel on a main channel, to implement an impedance tuning function. This is described in the following with reference to a specific antenna radiator structure and FIG. 5a to FIG. 5i. In FIG. 5a to FIG. 5f, the antenna 14 includes a first antenna radiator 141, a ground point, and a feed point, where the antenna radiator is configured to receive a signal, or is configured to receive and transmit signals. The configurable tuned circuit 200 may form matching networks of different topology forms according to a requirement of the antenna 14, and the matching networks may be connected in series or in parallel on the main channel to implement the impedance tuning function.

In some embodiments, in an antenna system 301 shown in FIG. 5a, the matching network 133 is coupled between the first antenna radiator 141 and a feed point (feed, configured to provide a feed source for the antenna radiator) 142 of the antenna. The first node a is coupled to the feed point 142, and the second node b is coupled to the first antenna radiator 141. In some specific implementations, a tuning network (namely, another matching network) 151 may further be coupled between the ground point of the antenna and the first antenna radiator 141, to further tune the antenna. The tuning network 151 cooperates with the matching network 133 to implement a combined tuning function. For example, the tuning network 151 may include four switches and reactance elements that are respectively connected in parallel with the four switches. In FIG. 5a, a first tuning switch S5 and a first tuning element 205 are connected in series to form a first tuning branch, a second tuning switch S6 and a second tuning element 206 are connected in series to form a second tuning branch, a third tuning switch S7 and a third tuning element 207 are connected in series to form a third tuning branch, and a fourth tuning switch S8 and a fourth tuning element 208 are connected in series to form a fourth tuning branch. The first tuning branch, the second tuning branch, the third tuning branch, and the fourth tuning switch S8 are coupled in parallel between the first antenna 141 and the ground point. In another embodiment, the tuning network 151 may alternatively be in another topology structure. One or more of the first tuning element, the second tuning element, the third tuning element, and the fourth tuning element may be capacitors or inductors, and some or all of the first tuning element, the second tuning element, the third tuning element, and the fourth tuning element may be capacitors or inductors.

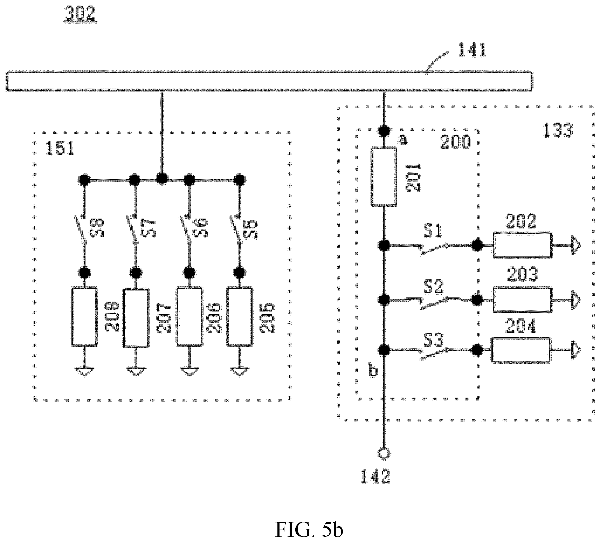

In some embodiments, in an antenna system 302 shown in FIG. 5b, the first node a of the matching network 133 is coupled to the first antenna radiator 141 and the second node b is coupled to the feed point 142. In FIG. 5a and FIG. 5b, when the impedance of the antenna changes, the conductive states of the first switching element S1, the second switching element S2, and the third switching element S3 may be configured to implement the impedance tuning function. In some specific implementations, the tuning network 151 may further be coupled between the ground point of the antenna and the first antenna radiator 141, to further tune the antenna. The tuning network 151 cooperates with the matching network 133 to implement a combined tuning function.

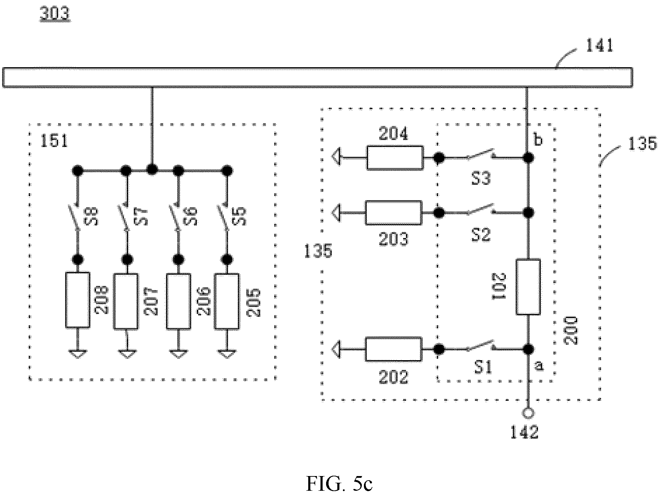

In some embodiments, in an antenna system 303 shown in FIG. 5c, the matching network 135 is coupled between the first antenna radiator 141 and the feed point (feed) 142 of the antenna. The first node a is coupled to the feed point 142, and the second node b is coupled to the first antenna radiator 141. In some specific implementations, the tuning network 151 may further be coupled between the ground point of the antenna and the first antenna radiator 141, to further tune the antenna. The tuning network 151 cooperates with the matching network 133 to implement a combined tuning function.

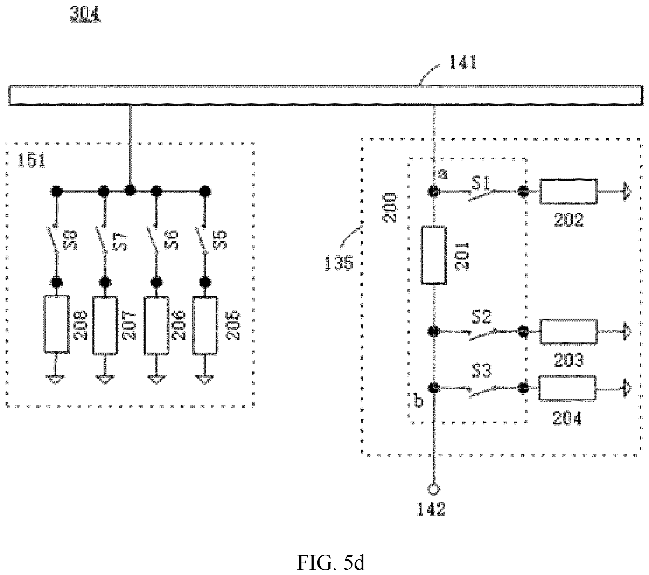

In some embodiments, in an antenna system 304 shown in FIG. 5d, the first node a of the matching network 135 is coupled to the first antenna radiator 141 and the second node b is coupled to the feed point 142. In some specific implementations, the tuning network 151 may further be coupled between the ground point of the antenna and the first antenna radiator 141, to further tune the antenna. The tuning network 151 cooperates with the matching network 133 to implement a combined tuning function. In FIG. 5c and FIG. 5d, when the impedance of the antenna changes, the conductive states of the first switching element S1, the second switching element S2, and the third switching element S3 may be configured to implement the impedance tuning function.

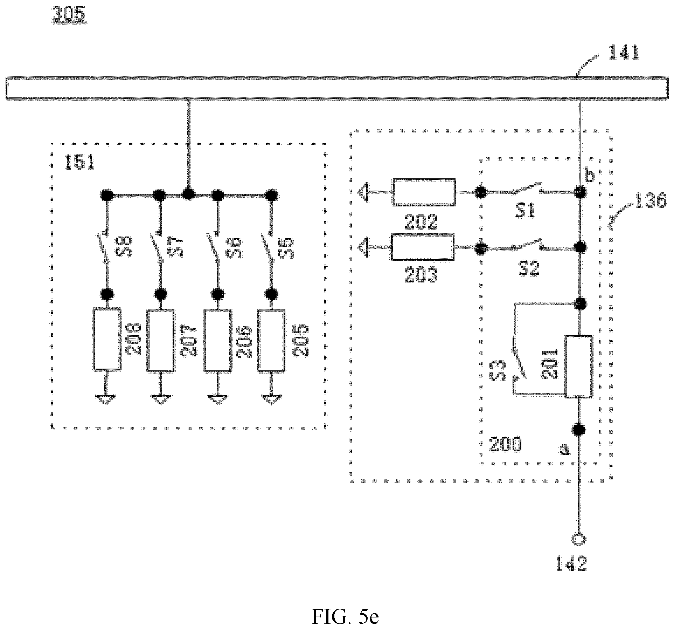

In some embodiments, in an antenna system 305 shown in FIG. 5e, the matching network 136 is coupled between the first antenna radiator 141 and the feed point (feed) 142 of the antenna. The first node a is coupled to the first antenna radiator 141, and the second node b is coupled to the feed point 142. In some specific implementations, the tuning network 151 may further be coupled between the ground point of the antenna and the first antenna radiator 141, to further tune the antenna. The tuning network 151 cooperates with the matching network 133 to implement a combined tuning function.

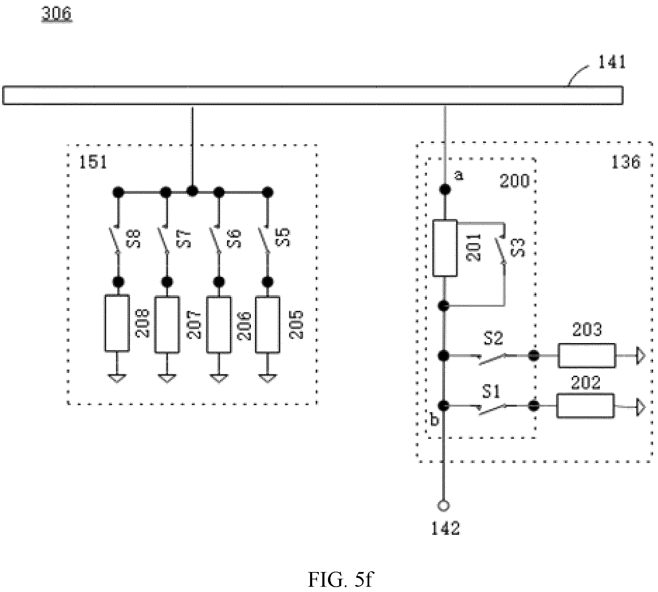

In some embodiments, in an antenna system 306 shown in FIG. 5f, the first node a of the matching network 136 is coupled to the feed point 142 and the second node b is coupled to the first antenna radiator 141. In some specific implementations, the tuning network 151 may further be coupled between the ground point of the antenna and the first antenna radiator 141, to further tune the antenna. The tuning network 151 cooperates with the matching network 133 to implement a combined tuning function. In FIG. 5e and FIG. 5f, when the impedance of the antenna changes, the conductive states of the first switching element S1, the second switching element S2, and the third switching element S3 may be configured to implement the impedance tuning function.

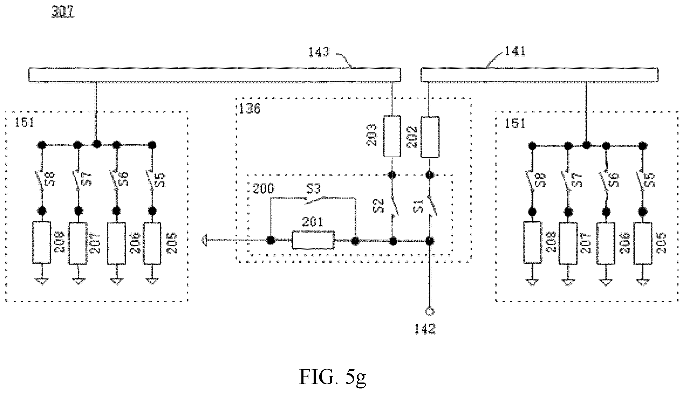

In FIG. 5g to FIG. 5h, the configurable tuned circuit 200 may implement a different antenna switching selection according to a requirement of the antenna 14. In some embodiments, in an antenna system 307 shown in FIG. 5g, the antenna 14 includes the first antenna radiator 141 and a second antenna radiator 143 (operating frequency bands of different antenna radiators may be the same or different). The first switching element S1 is connected in series with the second reactance element 202 to form a first branch. The second switching element S2 is connected in series with the third reactance element 203 to form a second branch. The third switching element S3 is connected in parallel with the first reactance element 201 to form a third branch. The first branch is coupled between the feed point 142 and the first antenna radiator 141, the second branch is coupled between the feed point 142 and the second antenna radiator 143, and the third branch is coupled between the feed point 142 and the ground. In FIG. 5g, the conductive states of the first switching element S1 and the second switching element S2 may be configured, to selectively conduct the first antenna radiator 141 or the second antenna radiator 143. When the first switching element S1 is closed and the second switching element S2 is opened, the first antenna radiator 141 can transmit or receive a signal. When the first switching element S1 is opened and the second switching element S2 is closed, the second antenna radiator 143 can transmit or receive a signal. When the first switching element S1 is closed and the second switching element S2 is closed, the first antenna radiator 141 and the second antenna radiator 143 may transmit or receive a signal. In addition, the conductive state of the third switching element S3 may be configured, to implement the impedance tuning function. In some specific implementations, the tuning network 151 may further be coupled between the ground point of the antenna and the first antenna radiator 141, and the tuning network 151 may further be coupled between the ground point of the antenna and the second antenna radiator 143, to further tune the antenna. The tuning network 151 cooperates with the matching network 133 to implement a combined tuning function.

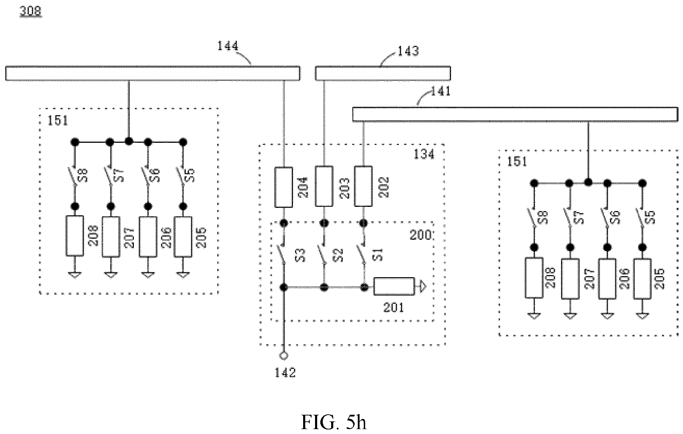

In some embodiments, in an antenna system 308 shown in FIG. 5h, the antenna 14 includes the first antenna radiator 141, the second antenna radiator 143, and a third antenna radiator 144 (operating frequency bands of different antenna radiators may be the same or different). The first switching element S1 is connected in series with the second reactance element 202 to form a first branch. The second switching element S2 is connected in series with the third reactance element 203 to form a second branch. The third switching element S3 is connected in parallel with the third reactance element 204 to form a third branch. The first branch is coupled between the feed point 142 and the first antenna radiator 141, the second branch is coupled between the feed point 142 and the second antenna radiator 143, and the third branch is coupled between the feed point 142 and the third antenna radiator 144. The first reactance element 201 is coupled between the feed point 142 and the ground. In FIG. 5h, the conductive states of the first switching element S1, the second switching element S2, and the third switching element S3 may be configured, to selectively conduct the first antenna radiator 141, the second antenna radiator 143, and the third antenna radiator 144, so that six selection states can be implemented. In some specific implementations, the tuning network 151 may further be coupled between the ground point of the antenna and the first antenna radiator 141, and the tuning network 151 may further be coupled between the ground point of the antenna and the third antenna radiator 144, to further tune the antenna. The tuning network 151 cooperates with the matching network 133 to implement a combined tuning function.

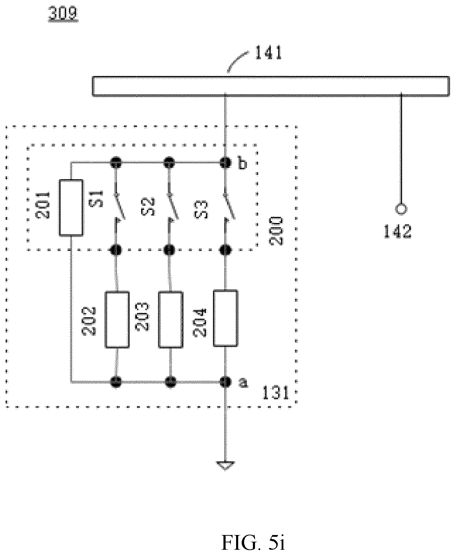

In some embodiments, a matching network may be coupled between an antenna radiator and a ground point, and the matching network may be used as an aperture tuning component connected in series with a ground feed of the antenna, to implement aperture tuning. For example, in an antenna system 309 shown in FIG. 5i, the matching network 131 is coupled between the first antenna radiator 141 and the ground point of the antenna. The first node a is coupled to the first antenna radiator 141, and the second node b is coupled to the ground point. The conductive states of the first switching element S1, the second switching element S2, and the third switching element S3 may be configured, to implement an aperture tuning function.

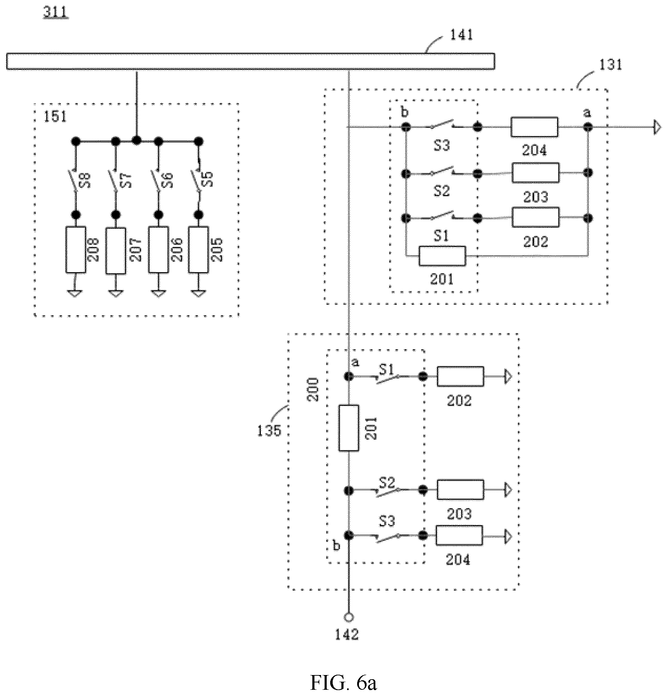

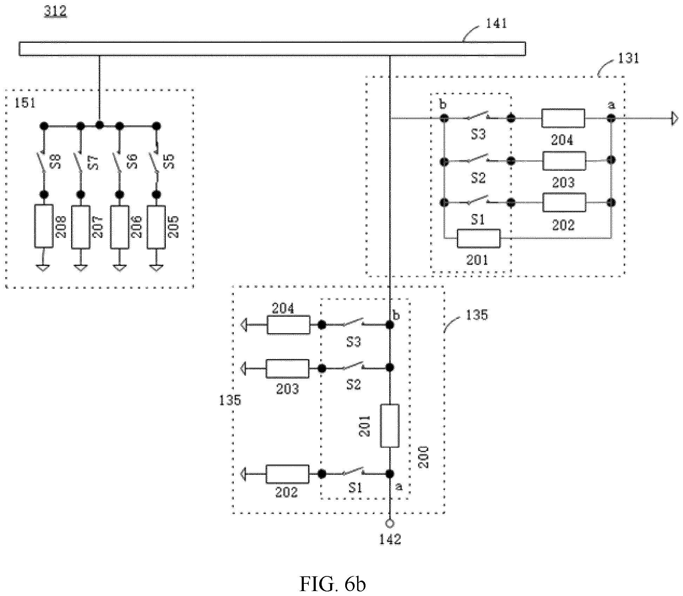

In some embodiments, the antenna system may further include a plurality of matching networks formed by a plurality of configurable tuned circuits 200, to implement more diversified combined tuning functions. In an antenna system 311 shown in FIG. 6a and an antenna system 312 shown in FIG. 6b, the matching network 131 and a matching network 135 may be coupled between the first antenna radiator 141 and the feed point 141. In some specific embodiments, in the antenna system 311 and the antenna system 312, the tuning network 151 may further be coupled between the ground point of the antenna and the first antenna radiator 141, and the tuning network 151 may further be coupled between the ground point of the antenna and the third antenna radiator 144, to further tune the antenna. The tuning network 151 cooperates with the matching network 131 or the matching network 135 to implement a combined tuning function.

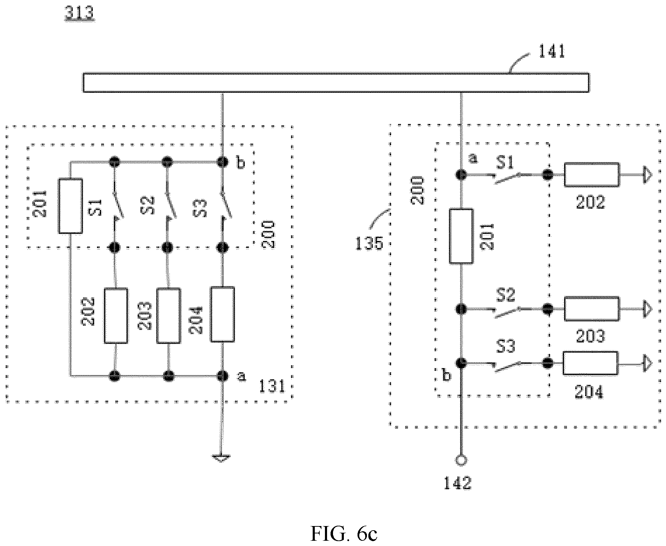

In some embodiments, in an antenna system 313 shown in FIG. 6c, the matching network 135 may be coupled between the first antenna radiator 141 and the feed point 141, and the matching network 131 may be coupled between the first antenna radiator 141 and the ground point, to implement a plurality of more flexible tuning.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments, and details are not described herein again.

In several embodiments provided in this application, it should be understood that the disclosed system, apparatus, and method may be implemented in another manner. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electrical, mechanical, or another form.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units may be integrated into one unit.

When the functions are implemented in the form of a software functional unit and sold or used as an independent product, the functions may be stored in a computer-readable storage medium. Based on such an understanding, the technical solutions of this application essentially, or the part contributing to the conventional technology, or some of the technical solutions may be implemented in a form of a software product. The computer software product is stored in a storage medium, and includes several instructions for instructing a computer device (which may be a personal computer, a server, or a network device) to perform all or some of the steps of the methods described in embodiments of this application. The foregoing storage medium includes any medium that can store program code, such as a USB flash drive, a removable hard disk, a read-only memory (read-only memory, ROM), a random access memory (random access memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A configurable tuned circuit, comprising:
a plurality of terminals, wherein the plurality of terminals comprise a first terminal, a second terminal, a third terminal, a fourth terminal, and a fifth terminal;
a first reactance element, wherein the first reactance element is coupled between the first terminal and the second terminal; and
a plurality of switching elements, wherein the plurality of switching elements comprise:
a first switching element, wherein the first switching element is coupled between the third terminal and the fourth terminal, and the first switching element selectively conducts the third terminal and the fourth terminal; and
a second switching element, wherein the second switching element is coupled between the second terminal and the fifth terminal, and the second switching element selectively conducts the second terminal and the fifth terminal.

2. The configurable tuned circuit according to claim 1, wherein the first reactance element is a variable capacitor.

3. The configurable tuned circuit according to claim 2, wherein a range of a capacitance value of the variable capacitor is 0.7 picofarad to 2.7 picofarads.

4. The configurable tuned circuit according to claim 2 or 3, wherein the variable capacitor is configured to switch between at least eight different capacitance values.

5. The configurable tuned circuit according to claim 2, wherein the first reactance element is a variable inductor.

6. The configurable tuned circuit according to any one of claims 1 to 5, wherein the plurality of terminals further comprise a sixth terminal; and
the plurality of switching elements further comprise a third switching element, the third switching element is coupled between the second terminal and the sixth terminal, and the second switching element selectively conducts the second terminal and the sixth terminal.

7. The configurable tuned circuit according to any one of claims 1 to 5, wherein the configurable tuned circuit further comprises at least one ground terminal, and the ground terminal is coupled to the first terminal.

8. The configurable tuned circuit according to claim 7, wherein the configurable tuned circuit comprises a first ground terminal and a second ground terminal, some terminals are connected to the first ground terminal, and some other terminals are connected to the second ground terminal.

9. The configurable tuned circuit according to claim 7, wherein a size of the ground terminal is the same as those of some or all of the plurality of terminals.

10. The configurable tuned circuit according to claim 1, wherein the configurable tuned circuit further comprises a signal controller, and the signal controller is separately coupled to the first switching element, the second switching element, and the first reactance element.

11. The configurable tuned circuit according to claim 10, wherein the plurality of terminals further comprise a user identification terminal, a ground terminal, a serial data terminal, a voltage input/output terminal, and a serial clock terminal, and the user identification terminal, the ground terminal, the serial data terminal, the voltage input/output terminal, and the serial clock terminal are separately coupled to the signal controller.

12. A matching network, comprising:
the configurable tuned circuit according to any one of claims 1 to 11; and
at least one external device, coupled to one or more of a plurality of switching elements through a terminal.

13. The matching network according to claim 12, comprising a plurality of external components, wherein each external component is coupled to one switching element.

14. The matching network according to claim 12, wherein the external component is a capacitor or an inductor.

15. An antenna system, comprising:
a first antenna radiator;
a feed point;
a ground point; and
at least one matching network according to any one of claims 12 to 14, wherein
the matching network is coupled between the first antenna radiator and the feed point, or the matching network is coupled between the first antenna radiator and the ground point; and
the matching network is coupled to the first antenna radiator, the feed point, or the ground point by using the terminal.

16. The antenna system according to claim 15, further comprising a second antenna radiator, wherein
the two switch elements are respectively connected in series with the two external components, to form a first branch and a second branch;
the first branch is coupled between the first antenna radiator and the feed point;
the second branch is coupled between the second antenna radiator and the feed point; and
the first reactance element is coupled between the feed point and the ground.

17. The antenna system according to claim 15 or 16, further comprising a tuning network, wherein the tuning network is coupled between the first antenna radiator and the ground point, and the matching network is coupled between the first antenna radiator and the feed point.

18. The antenna system according to claim 17, wherein the tuning network comprises:
a plurality of first tuning switches and a plurality of first tuning elements, wherein after being connected in series to one first tuning element, each first tuning switch is connected in parallel between the first antenna radiator and the ground point.

19. The antenna system according to claim 15 or 16, wherein the antenna system comprises two matching networks, and after the two matching networks are connected in series, the two matching networks are coupled between the first antenna radiator and the feed point; or
the antenna system comprises two matching networks, one matching network is coupled between the first antenna radiator and the feed point, and the other matching network is coupled between the first antenna radiator and the ground point.

20. A terminal device, comprising:
a processor; and
the antenna apparatus according to any one of claims 15 to 19, coupled to the processor.
